# EUROPEAN PATENT SPECIFICATION

(11) **EP 1 950 818 B1**
(45) Date of publication and mention of the grant of the patent: **23.12.2009**
(21) Application number: 08100585.2
(22) Date of filing: 17.01.2008
(51) Int. Cl.: H01L 51/54

(54) **Organic light-emitting device including fluorine-containing compound and carbon-based compound**
Organische, lichtemittierende Vorrichtung mit fluorhaltiger Verbindung und kohlenstoffhaltiger Verbindung
Dispositif électroluminescent organique incluant un composant contenant du fluor et un composant à base de carbone

(30) Priority: 24.01.2007 KR 20070007627
(43) Date of publication of application: 30.07.2008
(73) Proprietor: Samsung Mobile Display Co., Ltd., Suwon-si Gyeonggi-do (KR)
(72) Inventor: Kim, Tae-Shick, Gyeonggi-do (KR); Song, Ok-Keun., Gyeonggi-do (KR); Jeong, Hye-In, Gyeonggi-do (KR); Koo, Young-Mo, Gyeonggi-do (KR); Jun, Hyuk-Sang, Gyeonggi-do (KR)
(74) Representative: Hengelhaupt, Jürgen

(56) References cited:
- EP-A- 1 003 178
- EP-A- 1 653 529
- JP-A- 2001 247 498
- US-A1- 2005 062 406
- US-B1- 6 818 329
- ICHIKAWA ET AL: "Intense and efficient ultraviolet electroluminescence from organic light-emitting devices with fluorinated copper phthalocyanine as hole injection layer" THIN SOLID FILMS, ELSEVIER-SEQUOIA S.A. LAUSANNE, CH, vol. 515, no. 7-8, 13 December 2006 (2006-12-13), pages 3932-3935, XP005890816 ISSN: 0040-6090
- WEON-JONG KIM ET AL: "Electrical characteristics of organic light-emitting diodes with the thickness variation of buffer layer" ELECTRICAL INSULATING MATERIALS, 2005. (ISEIM 2005). PROCEEDINGS OF 20 05 INTERNATIONAL SYMPOSIUM ON KITAKYUSHU, JAPAN 5-9 JUNE 2005, PISCATAWAY, NJ, USA,IEEE, US, vol. 3, 5 June 2005 (2005-06-05), pages 640-643, XP010827896 ISBN: 978-4-88686-063-7
- QIU Y. ET AL.: "Efficient light emitting diodes with Teflon buffer layer" SYNTHETIC METALS, vol. 130, 20 October 2002 (2002-10-20), pages 235-237, XP002483836

## Description

### BACKGROUND OF THE INVENTION

### 1. Field of the Invention

Aspects of the present invention relate to an organic light-emitting device (OLED), and more particularly, to an organic light-emitting device with improved brightness, lifetime, and power consumption characteristics.

### 2. Description of the Related Art

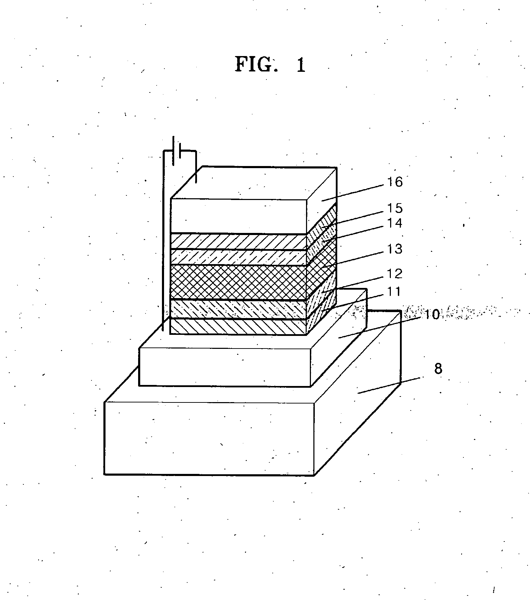

Organic light-emitting devices are devices that emit light by recombination of electrons and holes in an organic layer interposed between two electrodes when a current is supplied to the organic layer. A typical organic light-emitting device is illustrated in FIG. 1. Organic light-emitting devices have advantages such as high image quality, a rapid response speed, and a wide viewing angle, and thus, can embody lightweight and thin information display apparatuses. By virtue of such advantages, the organic light-emitting device technology has started to grow rapidly. Recently, the application field of organic light-emitting devices has expanded beyond mobile phones to other high-quality information display apparatuses.

M. Ichikawa et al. (Thin Solid Films 515 (2007), 3932-3935) disclose an ultraviolet OLED having the structure substrate/ITO/F₁₆CuPc/CBP/OXS-7/LiF/Al, wherein ITO is a first electrode (anode), F₁₆CuPc is a fluorine-substituted phthalocyanine derivative acting as a hole injection layer (HIL), CBP is a hole transport layer (HTL), OXS-7 is an emission layer (EmL), and Al is a second electrode (cathode).

W.-J. Kim et al. (Proceedings of 2005 International Symposium on Electrical Insulating Materials, June 5-9, 2005, Kitakyushu, Japan, 640-643) disclose an OLED comprising a glass substrate, an ITO electrode, a buffer layer having hole injecting properties, NBP acting as HTL, Alq₃ as emissive material and an Al electrode. The buffer layer may be composed of the aliphatic fluorocarbon compound polytetrafluoroethylene. The OLED disclosed in Y. Qiu et al. (Synthetic Metals 130 (2002), 235-237) has a similar structure as that of W.-J. Kim et al. and uses a buffer layer of PTFE reported to have hole injecting properties as well.

The OLED according to US 2005/0062406 A1 comprises a glass substrate, an ITO anode, a fist HIL made of copper phthalocyanine (CuPc), a second HIL made of fluorocarbon (CFx) by plasma CVD using CHF₃, an HTL made of NPD, an emission layer comprising Alq₃, and a cathode of MgIn alloy.

JP 2001-247498 describes an aromatic fluorine-containing compound (CₓF_{y}) comprising at least three aromatic rings arbitrary coupled or annealed to each other, wherein all C-H bonds are replaced by C-F bonds. The material is reported as having electron transporting and hole blocking properties. This document describes an OLED, wherein the aromatic fluorocarbon compound functions as an electron transport layer disposed between an emission layer and an electron injection layer and another OLED, wherein the aromatic fluorocarbon compound functions as hole blocking layer between the two emission layers.

With the rapid development of organic light-emitting devices, organic light-emitting devices should inevitably compete with other information display devices, such as TFT-LCDs, in terms of science and industrial applications. Conventional display devices are now facing technical limitations in terms of efficiency, lifetime, and power consumption of the devices that significantly affect the quantitative and qualitative growth of the devices.

### SUMMARY OF THE INVENTION

Aspects of the present invention provide an organic light-emitting device capable of enhancing lifetime, brightness, and power consumption efficiency.

According to an aspect of the present invention, there is provided an organic light-emitting device including: a substrate; a first electrode disposed on the substrate; a hole transport layer disposed on the first electrode; an emitting layer disposed on the hole transport layer; and a second electrode disposed on the emitting layer, wherein an organic layer is interposed between the first electrode and the hole transport layer, the organic layer including at least one fluorine-containing compound selected from the group consisting of an aliphatic fluorocarbon compound selected from the group consisting of C₄F₁₀, C₅F₁₂, C₆F₁₄, C₇F₁₆, C₃F₄, C₄F₆, C₂F₄, C₃F₆, C₄F₈, C₅F₁₀, C₆F₁₂, and C₇F₁₄, an aromatic fluorocarbon compound selected from the group consisting of C₆F₆, C₁₂F₁₀, C₁₈F₁₄, C₂₄F₁₈, and C₄₂F₃₀, and a fluorinated fullerene .

According to another aspect of the present invention, there is provided an organic light-emitting device including: a substrate; a first electrode disposed on the substrate; a hole injection layer disposed on the first electrode; an emitting layer disposed on the hole injection layer; and a second electrode disposed on the emitting layer, wherein an organic layer is interposed between the hole injection layer and the emitting layer, the organic layer including at least one fluorine-containing compound selected from the group consisting of an aliphatic fluorocarbon compound selected from the group consisting of C₄F₁₀, C₅F₁₂, C₆F₁₄, C₇F₁₆, C₃F₄, C₄F₆, C₂F₄, C₃F₆, C₄F₈, C₅F₁₀, C₆F₁₂, and C₇F₁₄, an aromatic fluorocarbon compound selected from the group consisting of C₆F₆, C₁₂F₁₀, C₁₈F₁₄, C₂₄F₁₈, and C₄₂F₃₀, and fluorinated fullerene.

A buffer layer made of a carbon-based compound may be further disposed on at least one surface of the organic layer that includes the fluorine-containing compound.

Organic light-emitting devices according to aspects of the present invention can show high efficiency, a low driving voltage, high brightness, and a long lifetime.

Additional aspects and/or advantages of the invention will be set forth in part in the description which follows and, in part, will be obvious from the description, or may be learned by practice of the invention.

### BRIEF DESCRIPTION OF THE DRAWINGS

These and/or other aspects and advantages of the invention will become apparent and more readily appreciated from the following description of the embodiments, taken in conjunction with the accompanying drawings of which:
FIG. 1 is a schematic view illustrating a conventional organic light-emitting device;
FIG. 2 is a schematic view illustrating an organic light-emitting device according to an example embodiment of the present invention; and
FIG. 3 is a schematic view illustrating an organic light-emitting device according to another example embodiment of the present invention.

### DETAILED DESCRIPTION OF THE EMBODIMENTS

Reference will now be made in detail to the present embodiments of the present invention, examples of which are illustrated in the accompanying drawings, wherein like reference numerals refer to the like elements throughout. The embodiments are described below in order to explain the present invention by referring to the figures.

According to aspects of the present invention, in order to adjust an interface between layers constituting an organic light-emitting device, a thin film including a fluorine-containing compound is interposed between an anode and a hole injection layer (or a hole transport layer) to thereby produce an organic light-emitting device with a low power consumption together with a drop in the driving voltage.

Aspects of the present invention provide an organic light-emitting device including: a substrate; a first electrode disposed on the substrate; a hole transport layer disposed on the first electrode; an emitting layer disposed on the hole transport layer; and a second electrode disposed on the emitting layer, wherein an organic layer is interposed between the first electrode and the hole transport layer, the organic layer including at least one fluorine-containing compound selected from the group consisting of an aliphatic fluorocarbon compound selected from the group consisting of C₄F₁₀, C₅F₁₂, C₆F₁₄, C₇F₁₆, C₃F₄, C₄F₆, C₂F₄, C₃F₆, C₄F₈, C₅F₁₀, C₆F₁₂, and C₇F₁₄, an aromatic fluorocarbon compound selected from the group consisting of C₆F₆, C₁₂F₁₀, C₁₈F₁₄, C₂₄F₁₈, and C₄₂F₃₀, and a fluorinated fullerene.

Herein, in general, when it is mentioned that one layer or material is formed on or disposed on a second layer or a second material, it is to be understood that the terms "formed on" and "disposed on" are not limited to the one layer being formed directly on the second layer, but may include instances wherein there is an intervening layer or material between the one layer and the second layer. Likewise, when it is mention that a third layer is interposed between a first and second layer, it is to be understood that other layers may be present between the one layer and the second layer.

The fluorinated fullerene is a fullerene-based compound containing at least one fluorine. Fullerene, which is also called "bucky ball", is formed through the binding of carbons that are separated from a surface of a graphite target when strong laser is irradiated onto the graphite target in a vacuum system. That is, fullerene is a carbon allotrope, and preferably, may be a carbon material having 20-500 carbon atoms. A representative example of a fullerene molecule is C60 which is made up of 60 carbon atoms. In addition, there are C70, C76, C84, etc. A reaction between a fullerene molecule and a fluorine atom produces fluorinated fullerene, e.g., C₆₀F₄₁, C₆₀F₄₂, C₆₀F₄₃, C₆₀F₄₈, or C₇₄F₃₈. As a non-limiting example, C₆₀F₄₂ may be used herein as the fluorinated fullerene.

Among the aforementioned groups, the fluorine-containing compound is preferably chosen from the group comprising C₆₀F₄₂, C₆F₆, C₁₂F₁₀, C₁₈F₁₄, C₂₄F₁₈, C₄₂F₃₀, C₄F₁₀, C₅F₁₂, C₆F₁₄, C₇F₁₆, C₃F₄, C₄F₆, C₂F₄, C₃F₆, C₄F₈, C₅F₁₀, C₆F₁₂, or C₇F₁₄.

As a non-limiting example, the organic light-emitting device according to aspects of the present invention may further include a buffer layer made of a carbon-based compound. The buffer layer may be disposed on a surface or on both surfaces of the organic layer that includes the fluorine-containing compound.

As a non-limiting example, the carbon-based compound may be at least one selected from the group consisting of fullerene, a metal-containing fullerene-based complex, a carbon nanotube, a carbon fibre, a carbon black, graphite, carbine, MgC60, CaC60, and SrC60.

The carbon-based compound is not particularly limited, but may include a metal-containing carbon-based compound (i.e., carbon complex) that is a carbon allotrope, and at the same time, a carbon material having 20-500 carbon atoms. As used herein, the carbon-based compound is at least one selected from the group consisting of fullerene, a metal-containing fullerene-based complex, a carbon nanotube, a carbon fibre, a carbon black, graphite, carbine, MgC60, CaC60, and SrC60. As a non-limiting example, the carbon-based compound may be a fullerene.

As described above, according to aspects of the present invention, when the buffer layer made of the carbon-based compound is disposed on the organic layer that includes the fluorine-containing compound, a driving voltage can be further lowered, thereby improving efficiency and lifetime characteristics.

The organic light-emitting device according to aspects of the present invention may further include a hole injection layer on the organic layer or on the buffer layer, if present.

The organic light-emitting device according to aspects of the present invention may further include at least one selected from a hole blocking layer, an electron injection layer, and an electron transport layer between the emitting layer and the second electrode.

Aspects of the present invention also provide an organic light-emitting device including: a substrate; a first electrode disposed on the substrate; a hole injection layer disposed on the first electrode; an emitting layer disposed on the hole injection layer; and a second electrode disposed on the emitting layer, wherein an organic layer is interposed between the hole injection layer and the emitting layer, the organic layer including at least one fluorine-containing compound selected from the group consisting of an aliphatic fluorocarbon compound selected from the group consisting of C₄F₁₀, C₅F₁₂, C₆F₁₄, C₇F₁₆, C₃F₄, C₄F₆, C₂F₄, C₃F₆, C₄F₈, C₅F₁₀, C₆F₁₂, and C₇F₁₄, an aromatic fluorocarbon compound selected from the group consisting of C₆F₆, C₁₂F₁₀, C₁₈F₁₄, C₂₄F₁₈, and C₄₂F₃₀, and a,fluorinated fullerene.

The organic light-emitting device according to the latter aspect includes a hole injection layer, unlike the above-described organic light-emitting device.

The organic light-emitting device according to the present invention may further include a hole transport layer on the hole injection layer, the organic layer, or a buffer layer that may be further disposed on the organic layer.

The aliphatic fluorocarbon compound, the aromatic fluorocarbon compound, and the fluorinated fullerene are as described above.

As anon-limiting example, the organic light-emitting device according to aspects of the present invention may further include a buffer layer including a carbon-based compound on a surface or both surfaces of the organic layer including the fluorine-containing compound. The carbon-based compound may be a carbon-based compound as described with respect to the buffer layer in the embodiment discussed above.

The organic light-emitting device according to aspects of the present invention may further include a hole transport layer on the organic layer or on the buffer layer, if present.

The organic light-emitting device according to aspects of the present invention may further include at least one selected from a hole blocking layer, an electron injection layer, and an electron transport layer between the emitting layer and the second electrode.

An organic layer included in an organic light-emitting device according to aspects of the present invention includes a fluorine-containing compound, thereby improving the deposition and interface characteristics of layers constituting the organic light-emitting device. As described above, an organic layer including a fluorine-containing compound resists morphological changes in a thin film state, and the fluorine-containing compound does not affect the colour coordinates characteristics of an organic light-emitting device. At this time, when changing an interfacial energy band gap between indium tin oxide (ITO) used in an anode and a hole injection layer or a hole transport layer, the injection of holes from ITO into the organic layer can be further facilitated, thereby lowering a driving voltage. Moreover, the organic layer including the fluorine-containing compound can serve as a stable buffer layer at an interface between ITO used in the anode and the hole injection layer, thereby increasing the lifetime of an organic light-emitting device.

An organic light-emitting device according to aspects of the present invention includes an organic layer including a fluorine-containing compound, and may further include a buffer layer including a carbon-based compound. Still further, in order to further adjust the interfacial characteristics of layers constituting an organic light-emitting device according to aspects of the present invention, at least one selected from a hole injection layer, a hole transport layer, an emitting layer, a hole blocking layer, an electron transport layer, and an electron injection layer may be doped with a carbon-based compound such as fullerene. Here, the carbon-based compound is as described above with respect to the carbon-based compound used in the buffer layer.

The content of the carbon-based compound may be 0.005 to 99.95 parts by weight based on the total weight (100 parts by weight) of each of the hole injection layer, the hole transport layer, the emitting layer, the hole blocking layer, the electron transport layer, and the electron injection layer. If the content of the carbon-based compound is outside the range, an organic light-emitting device may have unsatisfactory characteristics.

In an organic light-emitting device according to aspects of the present invention, an organic layer including a fluorine-containing compound may be formed by a method such as deposition, Langmuir Blodgett (LB) method, e-beam, sputtering, or spin-coating, as non-limiting examples. The thickness of the organic layer may be 0.1 to 50 nm (1 to 500 Å). If the thickness of the organic layer is less than 0.1 nm (1 Å), it may be difficult to control the thickness and to reproduce film characteristics. On the other hand, if the thickness of the organic layer exceeds 50 nm (500 Å), a driving voltage may be increased.

In an organic light-emitting device according to aspects of the present invention, a buffer layer including a carbon-based compound may be formed by a method such as deposition, as a non-limiting example. The thickness of the buffer layer may be 2 to 10 nm (20 to 100Å). As a non-limiting example, the thickness of the buffer layer may be 2 to 3 nm (20 to 30Å). If the thickness of the buffer layer is less than 2 nm (20Å), an improvement in characteristics of an organic light-emitting device may be insignificant. On the other hand, if the thickness of the buffer layer exceeds 10 nm (100Å), the characteristics of an organic light-emitting device, e.g., lifetime, contrast, or pixel short (in a PM type) may be improved, but a further reduction in driving voltage may not be achieved or a voltage gain width may be reduced.

FIG. 1 illustrates a conventional organic light-emitting device. Referring to FIG. 1, a conventional organic light-emitting device includes a substrate 8, a first electrode 10, a hole injection layer 11 is on the first electrode 10, and a hole transport layer 12, an emitting layer 13, an electron transport layer 14, an electron injection layer 15, and a second electrode 16 sequentially stacked on the hole injection layer 11.

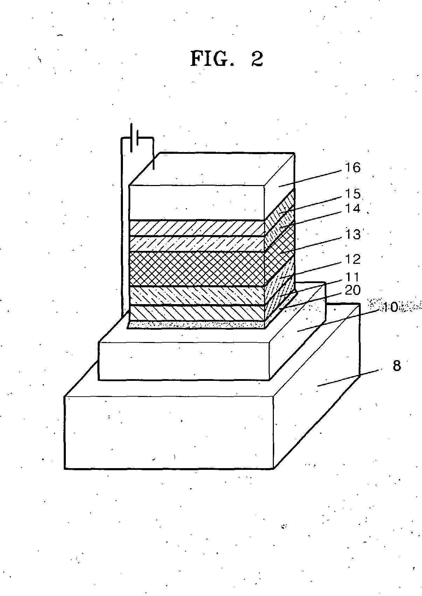

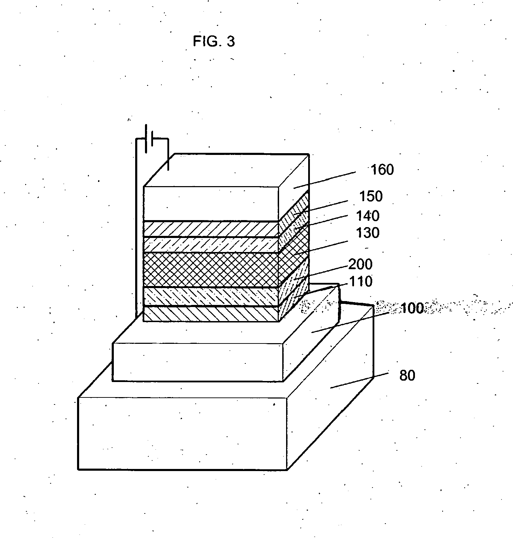

FIG. 2 and FIG. 3 are schematic views illustrating organic light-emitting devices according to example embodiments of the present invention. In the organic light-emitting device illustrated in FIG. 2, an organic light-emitting device according to an example embodiment includes a substrate 8, a first electrode 10, a hole injection layer 11 disposed on a first electrode 10 and a hole transport layer 12, an emitting layer 13, an electron transport layer 14, an electron injection layer 15, and a second electrode 16 sequentially stacked on the hole injection layer 11. An organic layer 20 including a fluorine-containing compound is interposed between the first electrode 10 and the hole injection layer 11. A buffer layer (not shown) may be further disposed on the organic layer 20. The hole injection layer 11 may be omitted.

Although not shown in FIG. 2, a hole blocking layer may be further disposed, In addition, it is possible to further form intermediate layers for improving interlayer interfacial characteristics. Moreover, as described above, the hole injection layer 11, the hole transport layer 12, the emitting layer 13, the electron transport layer 14, or the electron injection layer 15 may be doped with a carbon-based compound.

Referring to the organic light-emitting device illustrated in FIG. 3, an organic light-emitting device according to an example embodiment includes a substrate 80, a first electrode 100, a hole injection layer 110 disposed on a first electrode 100 and an emitting layer 130, an electron transport layer 140, an electron injection layer 150, and a second electrode 160 are sequentially stacked on the hole injection layer 110. An organic layer 200 including a fluorine-containing compound is interposed between the hole injection layer 110 and the emitting layer 130. A buffer layer (not shown) may be further disposed on the organic layer 20.

Hereinafter, a method of manufacturing an organic light-emitting device according to the example embodiments shown in FIGs. 2 and 3 will be described. For the sake of convenience, a method of manufacturing an organic light-emitting device according to an example embodiment of the present invention will be described with reference to FIG. 2. However, corresponding steps will apply for the manufacturing an organic light-emitting device according to FIG. 3 as well.

First, a first electrode 10 is patterned on a substrate 8. Here, the substrate 8 may be a substrate commonly used in organic light-emitting devices. As a non-limiting example, the substrate may be a glass or transparent plastic substrate that is excellent in transparency, surface smoothness, handling property, and water repellency. The thickness of the substrate may be 0.3 to 1.1 mm.

A material for forming the first electrode 10 may be a conductive metal facilitating hole injection or an oxide of a conductive metal. Non-limiting examples of a material for forming the first electrode include indium tin oxide (ITO), indium zinc oxide (IZO), nickel (Ni), platinum (Pt), gold (Au), or iridium (Ir).

The substrate 8 on which the first electrode 10 is formed is cleaned and then treated with UV/ozone. At this time, the cleaning may be performed using an organic solvent such as isopropanol (IPA) or acetone.

After the cleaning, a fluorine-containing compound is deposited on the first electrode 10 to form an organic layer 20 to a thickness of 0.1 to 50 nm (1 to 500 Å).

Next, a hole injection material is applied onto the organic layer 20 using vacuum thermal evaporation or spin coating to form a hole injection layer 11. As such, when the hole injection layer 11 is formed, a contact resistance between the first electrode 10 and an emitting layer 13 is reduced, and at the same time, hole transport capability of the first electrode 10 toward the emitting layer 13 is enhanced, thereby improving the driving voltage and lifetime characteristics of a device.

The thickness of the hole injection layer 11 may be 30 to 150 nm (300 to 1500 Å). If the thickness of the hole injection layer 11 is less than 30 nm (300 Å), the lifetime and reliability of an organic light-emitting device may be lowered. In particular, in a passive matrix (PM) organic light-emitting device, a pixel short may occur. On the other hand, if the thickness of the hole injection layer 11 exceeds 150 nm (1500 Å), a driving voltage may be increased.

The hole injection material is not particularly limited and may be copper phthalocyanine (CuPc) or a starburst-type amines such as TCTA, m-MTDATA, or IDE406 (Idemitsu), as non-limiting examples.

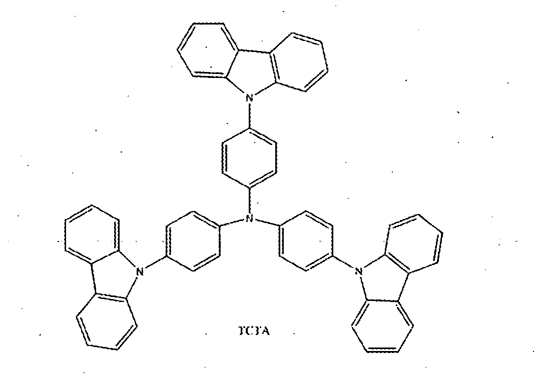

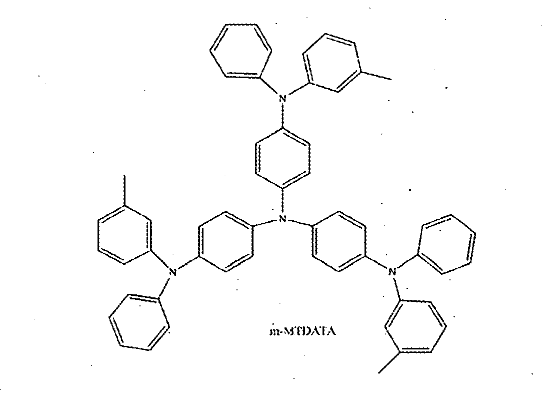

A hole transport material is applied onto the hole injection layer 11 using vacuum thermal evaporation or spin coating to form a hole transport layer 12. The hole transport material is not particularly limited and may be N,N'-bis(3-methylphenyl)-N,N'-diphenyl-[1,1-biphenyl]-4,4' diamine (TPD), N,N'-di(naphthalene-1-yl)-N,N'-diphenylbenzidine, N,N'-di(naphthalene-1-yl) -N,N'-diphenyl-benzidine (α-NPD), IDE320 (Idemitsu), or the like. The thickness of the hole transport layer 12 may be 10 to 40 nm (100 to 400 Å). If the thickness of the hole transport layer 12 is less than 10 nm (100 Å), hole transport capability may be lowered due to insufficient thickness. On the other hand, if the thickness of the hole transport layer 12 exceeds 40 nm (400 Å), a driving voltage may be increased.

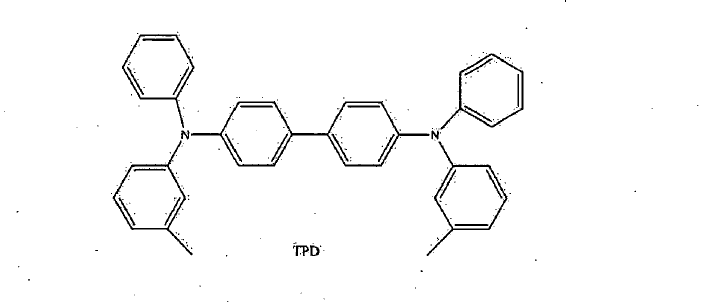

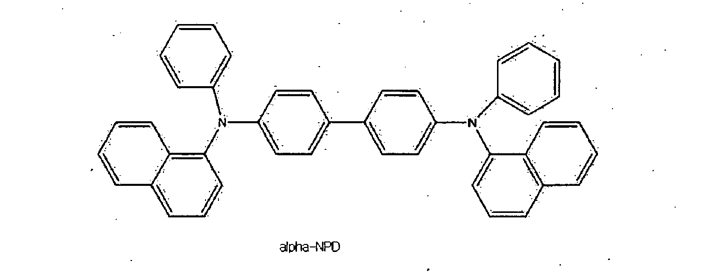

Next, the emitting layer 13 is formed on the hole transport layer 12.

An emitting layer material is not particularly limited and thus may be selected from emitting materials commonly known in the art. For example, the emitting layer material may be an aluminum complex (e.g.: Alq3 (tris(8-quinolinolato)-aluminum), BAlq, SAlq, Almq3), a gallium complex (e.g.: Gaq'₂OPiv, Gaq'₂OAc, 2(Gaq'₂)), a fluorene-based polymer, polyparaphenylene vinylene or its derivative, a biphenyl derivative, a spiropolyfluorene-based polymer, or the like.

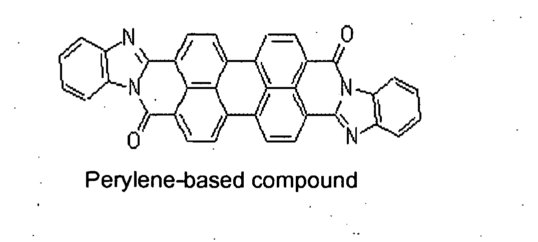

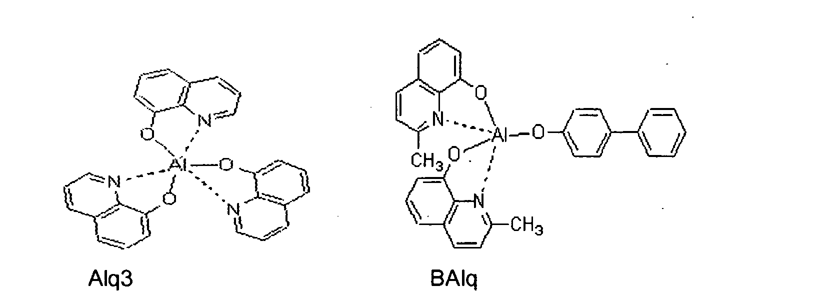

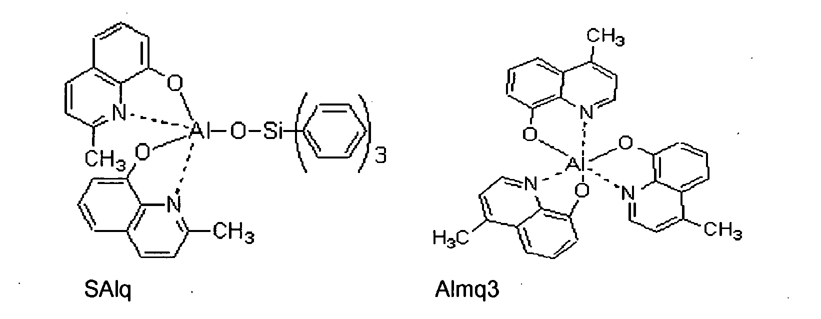

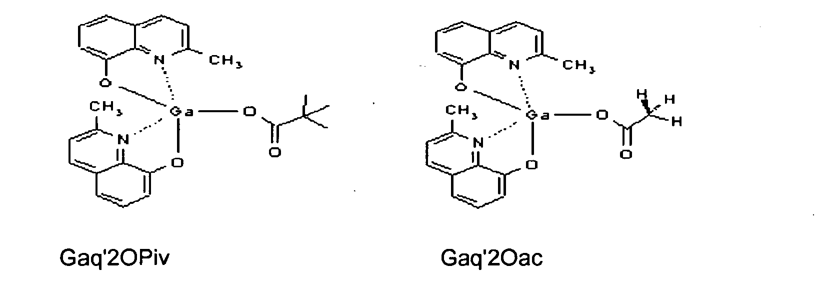

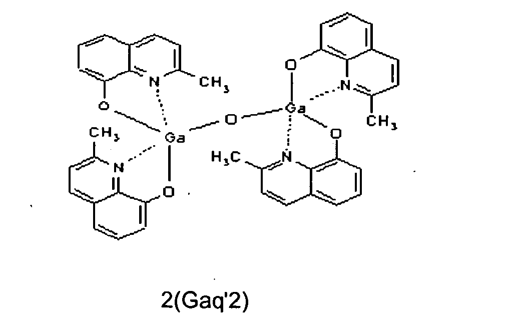

The thickness of the emitting layer 13 may be 30 to 50 nm (300 to 500 Å). As a non-limiting example, the thickness of the emitting layer 13 is 15 to 60 nm (150 to 600 Å). As the thickness of the emitting layer 13 increases, a driving voltage increases. In this regard, it is difficult to apply an emitting layer having a thickness more than 60 nm (600 Å).

Although not shown in FIG. 2, a hole blocking layer may be selectively formed on the emitting layer 13 by vacuum deposition or spin coating using a hole blocking material. The hole blocking material is not particularly limited but may be a material having electron transport capability and a higher ionization potential than an emitting compound. Non-limiting examples of the hole blocking material include Balq, BCP, or TPBI. The thickness of the hole blocking layer may be 3 to 7 nm (30 to 70 Å). If the thickness of the hole blocking layer is less than 3 nm (30 Å), hole blocking characteristics may not be realized efficiently. On the other hand, if the thickness of the hole blocking layer exceeds 7 nm (70 Å), a driving voltage may be increased.

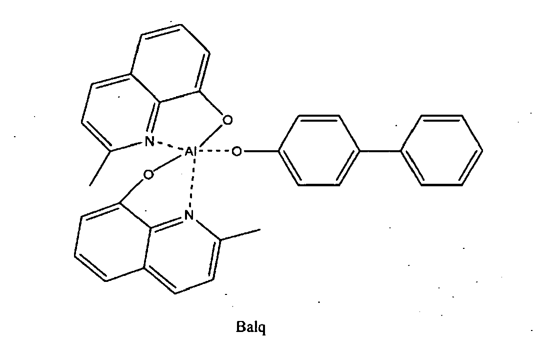

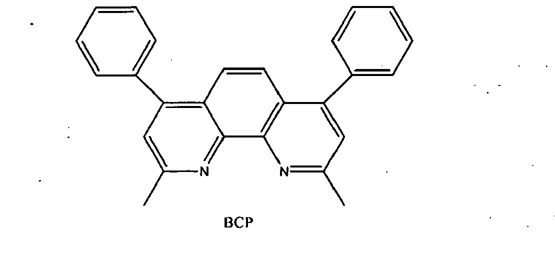

An electron transport material is applied onto the hole blocking layer, or onto the emitting layer 13 if the hole blocking layer is not present, using vacuum deposition or spin coating to form an electron transport layer 14. The electron transport material is not particularly limited and may be Alq3.

According to aspects of the present invention, the organic layer 20 including the fluorine-containing compound and/or a buffer layer including a carbon-based compound are/is interposed between the first electrode 10 and the hole injection layer 11. The hole injection layer 11, the hole transport layer 12, the emitting layer 13, the electron transport layer 14, or an electron injection layer 15 may be doped with a carbon-based compound.

That is, the organic layer 20 including the fluorine-containing compound and/or the buffer layer including the carbon-based compound are/is interposed between the first electrode 10 and the hole injection layer 11, and when forming at least one of the hole injection layer 11, the hole transport layer 12, the emitting layer 13, the electron transport layer 14, and the electron injection layer 15, a carbon-based compound may be co-deposited with a hole injection material, a hole transport material, or the like, using vacuum thermal evaporation. Here, the content of the carbon-based compound may be 0.005 to 99.95 parts by weight based on the total weight (100 parts by weight) of each of the hole injection layer 11, the hole transport layer 12, the emitting layer 13, the electron transport layer 14, and the electron injection layer 15. If the content of the carbon-based compound is less than 0.005 parts by weight, the characteristics of an organic light-emitting device may not be improved significantly.

The thickness of the electron transport layer 14 may be 15 to 60 nm (150 to 600 Å). If the thickness of the electron transport layer 14 is less than 15 nm (150 Å), electron transport capability may be lowered. On the other hand, if the thickness of the electron transport layer 14 exceeds 60 nm (600 Å), a driving voltage may be increased.

The electron injection layer 15 is formed on the electron transport layer 14. A material for forming the electron injection layer 15 may be LiF, NaCl, CsF, Li₂O, BaO, Liq, or the like. The thickness of the electron injection layer 15 may be 0.5 to 2 nm (5 to 20 Å). If the thickness of the electron injection layer 15 is less than 0.5 nm (5 Å), a function as an electron injection layer may not be performed. On the other hand, if the thickness of the electron injection layer 15 exceeds 2 nm (20 Å), a driving voltage may be increased.

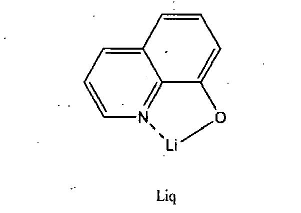

Next, a cathode metal is thermally vacuum-deposited on the electron injection layer 15 to form a second electrode 16, thereby completing the manufacture of an organic light-emitting device.

The cathode metal may be lithium (Li), magnesium (Mg), aluminum (Al), aluminum-lithium (Al-Li), calcium (Ca), magnesium-indium (Mg-In), magnesium-silver (Mg-Ag), or the like.

An organic light-emitting device according to aspects of the present invention may further include one or two intermediate layers between the anode, the hole injection layer, the hole transport layer, the emitting layer, the electron transport layer, the electron injection layer, and the cathode, when needed. In addition, when needed, an electron blocking layer may also be formed.

Hereinafter, aspects of the present invention will be described more specifically with reference to the following working examples. However, the following working examples are for illustrative purposes only and are not intended to limit the scope of the invention.

### Comparative Example

A 15 Ω/cm² ITO glass substrate (Corning, 1,200 Å) was cut into pieces of 50 mm x 50 mm x 0.7 mm in size, followed by ultrasonic cleaning in isopropyl alcohol and pure water (5 minutes for each), UV/ozone cleaning (30 minutes), and then plasma treatment under vacuum of 0.1 mtorr or less (9 minutes) to thereby form anodes. Then, m-MTDATA was vacuum-deposited on the anodes to form hole injection layers with a thickness of about 600 Å.

A green light-emitting material was thermally vacuum-deposited to a thickness of about 350 Å on the hole transport layers to form green light-emitting layers. Then, an electron transport material, Alq3 was deposited on the green light-emitting layers to form electron transport layers with a thickness of about 250 Å.

LiF (electron injection layers) and Al (cathodes) were sequentially thermally vacuum-deposited to thicknesses of about 10 Å and about 800 Å, respectively, on the electron transport layers to form LiF/Al electrodes, thereby completing organic green light-emitting devices as illustrated in FIG. 1.

### Example (not being part of the invention)

Organic light-emitting devices as illustrated in FIG. 2 were manufactured in the same manner as in the Comparative Example except that a fluorine-containing compound, F16CuPc, was deposited on the anodes to form organic layers before the m-MTDATA was deposited to form the hole injection layers.

The characteristics (efficiency, driving voltage) of the organic light-emitting devices including the organic layers with thicknesses of 5 Å and 10 Å (hereinafter, referred to as "samples 1 and 2", respectively) were evaluated.

### Evaluation Example

The brightness and driving voltage of the organic light-emitting devices were evaluated using a BM-5A (TOPCON) photometer and a 238 HIGH CURRENT SOURCE MEASURE UNIT (KEITHLEY). For each of the organic light-emitting devices manufactured in Comparative Example and Example, direct current (DC) was applied at intervals of 10 mA/cm² from 10 mA/cm² until the current reached 100 mA/cm² to thereby obtain nine or more different data values. The DC-based initial characteristics of the organic light-emitting devices are presented in Table 1 below.

**Table 1**

| | Comparative Example | Sample 1 | Sample 2 |
|---|---|---|---|
| ITO (ohm) | 15 | 15 | 15 |
| Driving voltage (V) | 8.4 | 6.8 | 7.0 |
| Efficiency (cd/A) | 9.0 | 9.3 | 9.2 |

| | | | |
|---|---|---|---|
| * Initial characteristics: evaluation at DC 100 mA/cm² | | | |

Referring to Table 1, the organic light-emitting devices according to the embodiments of the present invention exhibited a driving voltage that was reduced to 75% or less of the driving voltage of the conventional organic light-emitting devices, without affecting the colour coordinates.

That is, a driving voltage of the organic light-emitting devices according to the present invention was lowered 1 V or more relative to that of the conventional organic light-emitting devices.

An organic light-emitting device according to aspects of the present invention can show high efficiency, a low driving voltage, high brightness, and a long lifetime.

Although a few embodiments of the present invention have been shown and described, it would be appreciated by those skilled in the art that changes may be made in this embodiment without departing from the principles of the invention, the scope of which is defined in the claims and their equivalents.

## Claims

1. An organic light-emitting device comprising:
a substrate (8);
a first electrode (10) disposed on the substrate (8);
a hole transport layer (12) disposed on the first electrode (10);
an emitting layer (13) disposed on the hole transport layer (12); and
a second electrode (16) disposed on the emitting layer (13),
wherein an organic layer (20) is interposed between the first electrode (10) and the hole transport layer (12), the organic layer (20) comprising at least one fluorine-containing compound, **characterized in that** the fluorine-containing compound is selected from the group consisting of
a) an aliphatic fluorocarbon compound, selected from the group consisting of C₄F₁₀, C₅F₁₂, C₆F₁₄, C₇F₁₆, C₃F₄, C₄F₆, C₂F₄, C₃F₆, C₄F₈, C₅F₁₀, C₆F₁₂, and C₇F₁₄,
b) an aromatic fluorocarbon compound, selected from the group consisting of C₆F₆, C₁₂F₁₀, C₁₈F₁₄, C₂₄F₁₈, and C₄₂F₃₀, and
c) a fluorinated fullerene.

2. An organic light-emitting device comprising:
a substrate (80);
a first electrode (100) disposed on the substrate (80);
a hole injection layer (110) disposed on the first electrode (100);
an emitting layer (130) disposed on the hole injection layer (110); and
a second electrode (160) disposed on the emitting layer (130),
wherein an organic layer (200) is interposed between the hole injection layer (110) and the emitting layer (130), the organic layer (200) comprising at least one fluorine-containing compound, **characterized in that** the fluorine-containing compound is selected from the group consisting of
a) an aliphatic fluorocarbon compound, selected from the group consisting of C₄F₁₀, C₅F₁₂, C₆F₁₄, C₇F₁₆, C₃F₄, C₄F₆, C₂F₄, C₃F₆, C₄F₈, C₅F₁₀, C₆F₁₂, and C₇F₁₄,
b) an aromatic fluorocarbon compound, selected from the group consisting of C₆F₆, C₁₂F₁₀, C₁₈F₁₄, C₂₄F₁₈, and C₄₂F₃₀, and
c) a fluorinated fullerene.

3. The organic light-emitting device of claim 1 or 2, further comprising a buffer layer made of a carbon-based compound disposed on at least one surface of the organic layer (20, 200).

4. The organic light-emitting device of claim 1, further comprising a hole injection layer (11) disposed on the organic layer (20).

5. The organic light-emitting device of claims 1 and 3, further comprising a hole injection layer (11) disposed on the buffer layer.

6. The organic light-emitting device of claim 2, further comprising a hole transport layer disposed on the hole injection layer (110) or the organic layer (200).

7. The organic light-emitting device of claims 2 and 3, further comprising a hole transport layer disposed on the buffer layer.

8. The organic light-emitting device according to one of the preceding claims, further comprising at least one selected from a hole blocking layer, an electron injection layer (15, 150), and an electron transport layer (14, 140), disposed between the emitting layer (13, 130) and the second electrode (16, 160).

9. The organic light-emitting device according to one of the preceding claims,
wherein the thickness of the organic layer (20, 200) is 0.1 to 50 nm.

10. The organic light-emitting device of claim 3, wherein the thickness of the buffer layer is 2 to 10nm.

11. The organic light-emitting device according to one of the preceding claims, wherein the fluorine-containing compound is a fluorinated fullerene represented by C₆₀F₄₁, C₆₀F₄₂, C₆₀F₄₃, C₆₀F₄₈, or C₇₄F₃₈.

12. The organic light-emitting device of claim 3, wherein the carbon-based compound of the buffer layer is at least one selected from the group consisting of fullerene, a metal-containing fullerene-based complex, carbon nanotube, carbon fibre, carbon black, graphite, carbine, MgC60, CaC60, and SrC60.

13. The organic light-emitting device according to one of claims 1, 6 or 7, wherein at least one selected from the group consisting of the hole transport layer (12), and the emitting layer (13, 130), comprises a carbon-based compound.

14. The organic light-emitting device according to one of claims 2, 4 or 5, wherein at least one selected from the group consisting of the hole injection layer (11, 110), and the emitting layer (13, 130), comprises a carbon-based compound.

15. The organic light-emitting device of claim 8, wherein at least one selected from the group consisting of the hole injection layer (11, 110), the hole transport layer (12), the emitting layer (13, 130), the hole blocking layer, the electron transport layer (14, 140), and the electron injection layer (15, 150), comprises a carbon-based compound.

16. The organic light-emitting device of claim 15, wherein the content of the carbon-based compound is 0.005 to 99.95 parts by weight based on 100 parts by weight of each of the hole injection layer, the hole transport layer, the emitting layer, the hole blocking layer, the electron transport layer, and the electron injection layer.

## Patentansprüche

1. Organische, lichtemittierende Vorrichtung, aufweisend:
ein Substrat (8);
eine erste Elektrode (10), die auf dem Substrat (8) angeordnet ist;
eine Lochtransportschicht (12), die auf der ersten Elektrode (10) angeordnet ist;
eine Emissionsschicht (13), die auf der Lochtransportschicht (12) angeordnet ist; und
eine zweite Elektrode (16), die auf der Emissionsschicht (13) angeordnet ist,
wobei eine organische Schicht (20) zwischen der ersten Elektrode (10) und der Lochtransportschicht (12) eingefügt ist, wobei die organische Schicht (20) zumindest eine fluorhaltige Verbindung aufweist,
**dadurch gekennzeichnet, dass** die fluorhaltige Verbindung aus der Gruppe bestehend aus
a) einer aliphatischen Fluorkohlenstoffverbindung ausgewählt aus der Gruppe bestehend aus C₄F₁₀, C₅F₁₂, C₆F₁₄, C₇F₁₆, C₃F₄, C₄F₆, C₂F₄, C₃F₆, C₄F₈, C₅F₁₀, C₆F₁₂ und C₇F₁₄,
b) einer aromatischen Fluorkohlenstoffverbindung ausgewählt aus der Gruppe bestehend aus C₆F₆, C₁₂F₁₀, C₁₈F₁₄, C₂₄F₁₈ und C₄₂F₃₀, und
c) einem fluorierten Fulleren ausgewählt ist.

2. Organische, lichtemittierende Vorrichtung, aufweisend:
ein Substrat (80);
eine erste Elektrode (100), die auf dem Substrat (80) angeordnet ist;
eine Lochinjektionsschicht (110), die auf der ersten Elektrode (100) angeordnet ist;
eine Emissionsschicht (130), die auf der Lochinjektionsschicht (110) angeordnet ist; und
eine zweite Elektrode (160), die auf der Emissionsschicht (130) angeordnet ist,
wobei eine organische Schicht (200) zwischen der Lochinjektionsschicht (110) und der Emissionsschicht (130) eingefügt ist, wobei die organische Schicht (200) zumindest eine fluorhaltige Verbindung aufweist,
**dadurch gekennzeichnet, dass** die fluorhaltige Verbindung aus der Gruppe bestehend aus
a) einer aliphatischen Fluorkohlenstoffverbindung ausgewählt aus der Gruppe bestehend aus C₄F₁₀, C₅F₁₂, C₆F₁₄, C₇F₁₆, C₃F₄, C₄F₆, C₂F₄, C₃F₆, C₄F₈, C₅F₁₀, C₆F₁₂ und C₇F₁₄,
b) einer aromatischen Fluorkohlenstoffverbindung ausgewählt aus der Gruppe bestehend aus C₆F₆, C₁₂F₁₀, C₁₈F₁₄, C₂₄F₁₈ und C₄₂F₃₀, und
c) einem fluorierten Fulleren ausgewählt ist.

3. Organische, lichtemittierende Vorrichtung nach Anspruch 1 oder 2, weiterhin aufweisend eine aus einer kohlenstoffbasierten Verbindung hergestellte Pufferschicht, die auf zumindest einer Oberfläche der organischen Schicht (20, 200) angeordnet ist.

4. Organische, lichtemittierende Vorrichtung nach Anspruch 1, weiterhin aufweisend eine Lochinjektionsschicht (11), die auf der organischen Schicht (20) angeordnet ist.

5. Organische, lichtemittierende Vorrichtung nach den Ansprüchen 1 und 3, weiterhin aufweisend eine Lochinjektionsschicht (11), die auf der Pufferschicht angeordnet ist.

6. Organische, lichtemittierende Vorrichtung nach Anspruch 2, weiterhin aufweisend eine Lochtransportschicht, die auf der Lochinjektionsschicht (110) oder der organischen Schicht (200) angeordnet ist.

7. Organische, lichtemittierende Vorrichtung nach den Ansprüchen 2 und 3, weiterhin aufweisend eine Lochtransportschicht, die auf der Pufferschicht angeordnet ist.

8. Organische, lichtemittierende Vorrichtung nach einem der vorhergehenden Ansprüche, weiterhin aufweisend zumindest eine aus einer Lochblockierschicht, einer Elektroneninjektionsschicht (15, 150) und einer Elektronentransportschicht (14, 140) ausgewählte Schicht, die zwischen der Emissionsschicht (13, 130) und der zweiten Elektrode (16, 160) angeordnet ist.

9. Organische, lichtemittierende Vorrichtung nach einem der vorhergehenden Ansprüche, wobei die Dicke der organischen Schicht (20, 200) 0,1 bis 50 nm beträgt.

10. Organische, lichtemittierende Vorrichtung nach Anspruch 3, wobei die Dicke der Pufferschicht 2 bis 10 nm beträgt.

11. Organische, lichtemittierende Vorrichtung nach einem der vorhergehenden Ansprüche, wobei die fluorhaltige Verbindung ein fluoriertes Fulleren ist, das durch C₆₀F₄₁, C₆₀F₄₂, C₆₀F₄₃, C₆₀F₄₈ oder C₇₄F₃₈ repräsentiert wird.

12. Organische, lichtemittierende Vorrichtung nach Anspruch 3, wobei die kohlenstoffbasierte Verbindung der Pufferschicht zumindest eines ist, das aus der Gruppe bestehend aus Fulleren, einem metallhaltigen fullerenbasierten Komplex, einer Kohlenstoff-Nanoröhre, einer Kohlenstofffaser, Industrieruß, Graphit, Carbin, MgC60, CaC60 und SrC60 ausgewählt ist.

13. Organische, lichtemittierende Vorrichtung nach einem der Ansprüche 1, 6 oder 7, wobei zumindest eine Schicht, die aus der Gruppe bestehend aus der Lochtransportschicht (12) und der Emissionsschicht (13, 130) ausgewählt ist, eine kohlenstoffbasierte Verbindung aufweist.

14. Organische, lichtemittierende Vorrichtung nach einem der Ansprüche 2, 4 oder 5, wobei zumindest eine Schicht, die aus der Gruppe bestehend aus der Lochinjektionsschicht (11, 110) und der Emissionsschicht (13, 130) ausgewählt ist, eine kohlenstoffbasierte Verbindung aufweist.

15. Organische, lichtemittierende Vorrichtung nach Anspruch 8, wobei zumindest eine Schicht, die aus der Gruppe bestehend aus der Lochinjektionsschicht (11, 110), der Lochtransportschicht (12), der Emissionsschicht (13, 130), der Lochblockierschicht, der Elektronentransportschicht (14, 140) und der Elektroneninjektionsschicht (15, 150) ausgewählt ist, eine kohlenstoffbasierte Verbindung aufweist.

16. Organische, lichtemittierende Vorrichtung nach Anspruch 15,
wobei der Gehalt der kohlenstoffbasierten Verbindung 0,005 bis 99,95 Gewichtsteile, bezogen auf 100 Gewichtsteile von jeder der Lochinjektionsschicht, der Lochtransportschicht, der Emissionsschicht, der Lochblockierschicht, der Elektronentransportschicht und der Elektroneninjektionsschicht, beträgt.

## Revendications

1. Dispositif photoémetteur organique, comprenant :
un substrat (8) ;
une première électrode (10) disposée sur le substrat (8) ;
une couche de transport de lacunes (12) disposée sur la première électrode (10) ;
une couche émettrice (13) disposée sur la couche de transport de lacunes (12) et
une seconde électrode (16) disposée sur la couche émettrice (13),
dans lequel une couche organique (20) est interposée entre la première électrode (10) et la couche de transport de lacunes (12), la couche organique (20) comprenant au moins un composé contenant du fluor, **caractérisé en ce que** le composé contenant du fluor est choisi dans le groupe consistant en
a) un composé fluorocarboné aliphatique, choisi dans le groupe consistant en C₄F₁₀, C₅F₁₂, C₆F₁₄, C₇F₁₆, C₃F₄, C₄F₆, C₂F₄, C₃F₆, C₄F₈, C₅F₁₀, C₆F₁₂ et C₇F₁₄,
b) un composé fluorocarboné aromatique, choisi dans le groupe consistant en C₆F₆, C₁₂F₁₀, C₁₈F₁₄, C₂₄F₁₈ et C₄₂F₃₀ et
c) un fullérène fluoré.

2. Dispositif photoémetteur organique, comprenant :
un substrat (80) ;
une première électrode (100) disposée sur le substrat (80) ;
une couche d'injection de lacunes (110) disposée sur la première électrode (100) ;
une couche émettrice (130) disposée sur la couche d'injection de lacunes (110) et
une seconde électrode (160) disposée sur la couche émettrice (130),
dans lequel une couche organique (200) est interposée entre la couche d'injection de lacunes (110) et la couche émettrice (130), la couche organique (200) comprenant au moins un composé contenant du fluor, **caractérisé en ce que** le composé contenant du fluor est choisi dans le groupe consistant en
a) un composé fluorocarboné aliphatique, choisi dans le groupe consistant en C₄F₁₀, C₅F₁₂, C₆F₁₄, C₇F₁₆, C₃F₄, C₄F₆, C₂F₄, C₃F₆, C₄F₈, C₅F₁₀, C₆F₁₂ et C₇F₁₄,
b) un composé fluorocarboné aromatique, choisi dans le groupe consistant en C₆F₆, C₁₂F₁₀, C₁₈F₁₄, C₂₄F₁₈ et C₄₂F₃₀ et
c) un fullérène fluoré.

3. Dispositif photoémetteur organique suivant la revendication 1 ou 2, comprenant en outre une couche tampon constituée d'un composé à base de carbone disposée sur au moins une surface de la couche organique (20, 200).

4. Dispositif photoémetteur organique suivant la revendication 1, comprenant en outre une couche d'injection de lacunes (11) disposée sur la couche organique (20).

5. Dispositif photoémetteur organique suivant les revendications 1 et 3, comprenant en outre une couche d'injection de lacunes (11) disposée sur la couche tampon.

6. Dispositif photoémetteur organique suivant la revendication 2, comprenant en outre une couche de transport de lacunes disposée sur la couche d'injection de lacunes (110) ou la couche organique (200).

7. Dispositif photoémetteur organique suivant les revendications 2 et 3, comprenant en outre une couche de transport de lacunes disposée sur la couche tampon.

8. Dispositif photoémetteur organique suivant une des revendications précédentes, comprenant en outre au moins une couche choisie entre une couche de blocage de lacunes, une couche d'injection d'électrons (15, 150) et une couche de transport d'électrons (14, 140), disposée entre la couche émettrice (13, 130) et la seconde électrode (16, 160).

9. Dispositif photoémetteur organique suivant une des revendications précédentes, dans lequel l'épaisseur de la couche organique (20, 200) va de 0,1 à 50 nm.

10. Dispositif photoémetteur organique suivant la revendication 3, dans lequel l'épaisseur de la couche tampon va de 2 à 10 nm.

11. Dispositif photoémetteur organique suivant une des revendications précédentes, dans lequel le composé contenant du fluor est un fullérène fluoré représenté par C₆₀F₄₁, C₆₀F₄₂, C₆₀F₄₃, C₆₀F₄₈ ou C₇₄F₃₈.

12. Dispositif photoémetteur organique suivant la revendication 3, dans lequel le composé à base de carbone de la couche tampon est au moins un composé choisi dans le groupe consistant en un fullérène, un complexe à base de fullérène contenant un métal, un nanotube de carbone, une fibre de carbone, le noir de carbone, le graphite, un carbine, MgC60, CaC60 et SrC60.

13. Dispositif photoémetteur organique suivant une des revendications 1, 6 et 7, dans lequel au moins une couche est choisie dans le groupe consistant en la couche de transport de lacunes (12) et la couche émettrice (13, 130) comprend un composé à base de carbone.

14. Dispositif photoémetteur organique suivant une des revendications 2, 4 et 5, dans lequel au moins une couche est choisie dans le groupe consistant en la couche d'injection de lacunes (11, 110) et la couche émettrice (13, 130) comprend un composé à base de carbone.

15. Dispositif photoémetteur organique suivant la revendication 8, dans lequel au moins une couche choisie dans le groupe consistant en la couche d'injection de lacunes (11, 110), la couche de transport de lacunes (12), la couche émettrice (13, 130), la couche de blocage de lacunes, la couche de transport d'électrons (14, 140) et la couche d'injection d'électrons (15, 150) comprend un composé à base de carbone.

16. Dispositif photoémetteur organique suivant la revendication 15, dans lequel la quantité du composé à base de carbone est comprise dans l'intervalle de 0,005 à 99,95 parties en poids sur la base de 100 parties en poids de chacune des couches consistant en la couche d'injection de lacunes, la couche de transport de lacunes, la couche émettrice, la couche de blocage de lacunes, la couche de transport d'électrons et la couche d'injection d'électrons.
